# EUROPEAN PATENT SPECIFICATION

(11) **EP 2 307 236 B1**
(45) Date of publication and mention of the grant of the patent: **15.08.2018**
(21) Application number: 09774151.6
(22) Date of filing: 25.06.2009
(51) Int. Cl.: B60P 1/64, B63B 25/00, B64C 1/22, H05K 7/14

(54) **FASTENING DEVICE FOR A HOUSING IN A RECEIVING DEVICE**
BEFESTIGUNGSVORRICHTUNG FÜR EIN GEHÄUSE IN EINER EMPFANGSVORRICHTUNG
DISPOSITIF DE FIXATION POUR UN BOÎTIER DANS UN DISPOSITIF DE RÉCEPTION

(30) Priority: 01.07.2008 DE 102008030640
(43) Date of publication of application: 13.04.2011
(73) Proprietor: Abaco Systems, Inc., Huntsville, AL 35803 (US)
(72) Inventor: DEISENHOFER, Guenter, ID-86399 Bobingen (DE)
(74) Representative: Zimmermann & Partner Patentanwälte mbB
(86) International application number: PCT/US2009/048662
(87) International publication number: WO 2010/002700

(56) References cited:
- EP-A1- 0 337 856
- FR-A1- 2 372 375
- US-A- 2 917 266
- US-A- 3 035 806
- US-A- 3 429 534
- US-A1- 2007 251 857
- US-A1- 2008 101 883

## Description

### Background of the Invention

The present invention relates in general to fastening devices and in particular to the secure fastening of a housing, which is exposed to strong vibrations and impacts. Such a housing can, for example, contain electronic equipment of an aircraft, which during a flight can be located in a stationary frame or tray and be fastened there by means of a fastening device.

Among experts, fastening devices are well-known, which are frequently used for quadrangular-shaped housings, which can be slid into corresponding receiving devices. At the rear end turned away from an operator, a housing has, for example, several recesses, with which several spikes arranged in the slide-in direction engage, which are applied to the rear end of the receiving device. The spikes prevent a lateral movement of the rear end of the housing, as soon as the latter has been completely slid into the receiving device. In order to keep the spikes engaged and to fasten the housing, the front end of the housing is pretensioned, for example, with the help of a tensioning screw in the receiving device.

Although such fastening devices frequently fulfill their tasks, they have several disadvantages. The absorption of the arising weight and inertial forces at the rear end occurs in the spikes via relatively small cross-sectional areas, which can thus be exposed to high stresses just as the material of the housing contiguous to them. Furthermore, the dimensions in the housing and the receiving device must be very strictly adhered to, so that the spikes have neither an undesired lateral play nor have to be brought into engagement with the associated recesses of the housing under excessive pre-stressing.

Moreover, a tensioning screw located at the front end of the receiving device can indeed exert on the latter in its longitudinal direction a compressive force sufficient for the fastening of the housing, while its fastening effect can, however, be insufficient in the horizontal direction transversely to the slide-in direction, since this direction runs at right angles to the direction of the force produced by the screw. Particularly, in the case of very heavy housings and strong vibration- or impact stresses, the fastening effect can thus be insufficient.

FR 2 372 375 A1 describes a device for stowing a cabinet in an airplane. A rail having a trapezoidal cross-section is provided on the upper surface of a support. The rail ends in an inclined stop. A slide having a planar upper surface for receiving a cabinet can slide on the rail. The front surface of the slide is inclined in a sense opposite to the inclination of the stop. Two male elements are provided in notches of the slide. The male elements can be fastened with nuts. US 3 035 806 A relates to an apparatus for attaching a container to a base plate. A base plate is provided, to which is attached a supporting bracket. A locking plate is attached to the bottom of a removable member. Threaded shafts are receivable through ball and socket brackets.

It is assumed that the task of the invention is to create a fastening device, which is appropriate for the reception of heavy loads and makes low demands on the dimensional tolerances to be adhered to. This task is achieved with a fastening device with the characteristics of Claim 1:

### Brief Description of the Invention

In accordance with the invention, a fastening device for detachable mounting of a housing as set forth in claim 1 is provided. Further embodiments are inter alia disclosed in the dependent claims. The present invention creates a fastening device for the stationary, detachable mounting of housings in a receiving device, which has a guiding device for the support and guidance of the housing. The receiving device can be a box or have a hollow space appropriate for the reception of the housing. However, the fastening device according to the present invention does not need to enclose the housing, but rather could also be open and hold the housing, for example, with one side on a floor element.

Preferably, the receiving device is open at least toward a front side, which can be turned towards an operator, if the receiving device is, for example, built into a wall. Through the opening, the housing can be inserted by the operator into the receiving device and removed from the latter. The operator can also carry out actions through the opening, such as, for instance, actuation of switches and reading of instruments in the housing. The housing and the receiving device provided for its reception can be quadrangular boxes.

The guiding device serves for the support of the housing, i.e., for the reception by the housing of a force acting in the direction of the guiding device. The force can act in an approximately vertical direction and at least partially derive from the force of gravity acting upon the housing. However, other forces exerted by a tensioning device on the housing can overlay the force of gravity, which can also contain horizontal components and/or components not directed at the guiding device. Generally, however, at least one component of the force acting overall on the housing will produce a pre-stressing toward the guiding device. The direction of the force acting from the housing on the guiding device is characterized below in accordance with a preferred embodiment as a vertical direction, in which the force of gravity of a housing resting above acts on an essentially horizontal guiding device. However, the fastening device according to the present invention could also be located in any other arrangement in the area, in which the pre-stressing between the housing and the guiding device can be produced in another way, for example, with the aid of a tensioning device.

Furthermore, the guiding device serves for the guidance of the housing, in that it permits only certain movements of the housing relative to the receiving device. The guiding device, for example, can have a flat surface, which is arranged at right angles to the vertical direction and permits movements of the equipment housing alongside it in two horizontal dimensions.

The fastening device also has a carriage element, which is located on an outer surface of the housing. The carriage element can be brought into and out of engagement with the guiding device and can be slid into engagement in relation to the guiding device. Preferably, the carriage element is located at or under a floor area of the housing, in which the housing is located in the vertical direction over the guiding device. In contrast to other arrangements, the force of gravity thus already provides a contribution to the force required in the vertical direction for the fastening.

The fastening device also has a first tensioning device, which is located adjacent to a front side of the housing. The tensioning device is equipped for the purpose of pre-stressing the housing on its front end against the guiding device, if the housing is arranged in the position located in the receiving device.

The fastening device also has a second tensioning device, which is located adjacent to a rear side of the housing, in order to pre-stress the housing in a slide-in position at its rear end against the guiding device. The pre-stressing occurs preferably in the vertical direction through a compressive force exerted by the equipment housing against the guiding device. As long as the housing is arranged in the vertical direction over the guiding device, the forces exerted by the first and second tensioning device thereby reinforce the effect of the force of gravity acting on the housing.

The guiding device can also have at least one guiding rail, which defines a guiding direction. The guide rail can permit movements of the housing relative to the guiding device in the guiding direction and prevent movements transverse to the guiding direction towards one or towards both sides. Also, two parallel guide rails can exist, which prevent a movement of the housing in each case toward a side transverse to the guiding direction. The one or the several guide rails can thereby form a linear guide of the housing, which permits only a one-dimensional movement of the housing in the guiding direction. However, they can additionally also permit a play transverse to the guiding direction. This can be advantageous, if the housing, for example, has plug connectors or similar connecting elements on its rear side, which have to be oriented towards associated stationary elements, before they can be brought into engagement.

The guiding direction is preferably approximately horizontal, so that also heavy loads can be shifted or oriented in the guiding direction, for example, by hand, without components of the force of gravity having to be overcome thereby at the same time.

Preferably, the at least one guide rail has a transversely arranged bearing surface. It can have a wedge profile with an inclined plane, in which the edge of the wedge extends preferably in the guiding direction. Through its vertical extension, the guide rail can prevent or make difficult a horizontal movement of the housing transverse to the guiding direction, if the guide rail acts together with appropriate structures, such as, for example, projections, recesses, or skids on the bottom side of the housing.

Advantageously, the same or a second guide rail can have another bearing surface arranged transversely, which can have a vertical plane running in the guiding direction with an oppositely directed inclination. Both of the transverse bearing surfaces of the one or the two guide rails can be arranged horizontally side by side and are commonly regarded as a guideway with a trapezoidal cross-section, whose legs are formed from the transversely arranged bearing surfaces. The trapezoid is preferably symmetrical, i.e., the inclinations of the oppositely inclined planes have the same amount. It is thus achieved, that equally large vertical forces produce equally large, horizontal inclination forces directed against each other and thus forces transverse to the guiding direction are avoided in the sum.

Preferably, the cross-section of the guide rail(s) is so designed, that it is tapered upwards in the vertical direction. It can be a matter of a projection with trapezoidal cross-section, which becomes narrower upwards, or a groove with a trapezoidal cross-section, which becomes wider upwards. In both cases the possibility is created, that appropriate projections on the housing, for example, skids extending under a floor area of the housing in the guiding direction, can be brought into contact in the set up of the housing with both transverse bearing surfaces from above without play, whereby the housing can be shifted in the guiding direction.

The one or the several guide rails can produce a lateral guide. The housing can be mounted in a linear movement in the guiding direction. Preferably, the guiding direction is a horizontal direction and thus essentially at right angles to the vertical direction, in which the force of gravity and components of the forces exerted by tensioning devices can operate. The housing is thus relatively easily movable horizontally in a detached state, so that it can be slid into the receiving device or detached from the latter manually by an operator, for example, with the aid of a hand grip applied to the housing . However, in the fastened state, a large vertical force ensures a secure seat of the housing on the guiding device.

Preferably, the carriage element of the fastening device has at least one skid. The skid can extend straight and permit an arrangement of possible guide rails of the guiding device in the guiding direction. The skid can have a bearing surface arranged transversely, which forms a wedge, which extends with a corresponding arrangement of the carriage element in the guiding direction of a guide rail. The carriage element can have a further, transversely arranged bearing surface. At the same time, either one skid can have two transversely arranged bearing surfaces, or a second skid can exist, which has the second transversely arranged bearing surface.

The two bearing surfaces can jointly form a guideway with a trapezoidal cross-section, in which the bearing surfaces in the cross-section correspond to the legs of the trapezoid. The guideway can form a projection tapering downwards, projecting downwards from the carriage element. In this way, undercutting structures are avoided and a set up of the carriage element on the guiding device from above is permitted in the vertical direction. The carriage element could also have a groove narrowing upwards with trapezoid cross-section, in which preferably a symmetrical trapezoidal form is used. In a preferred embodiment, both the guiding device as well as the carriage element have in each case two bearing surfaces extending in the guiding direction, which looked at in cross-section form in each case the legs of a trapezoid. In this way, the housing can be so arranged in the guiding device, that the carriage element lies flat against in each case two bearing surfaces on the guiding device and produces slight stresses. Moreover, a housing inserted, if necessary, imprecisely, namely shifted laterally, exerts a centering force on the carriage element.

Preferably, two guide rails of the guiding device and two associated skids of the carriage element can be arranged spaced apart from one another in the horizontal direction. Thus, a greater width between supports is created and the transfer of transverse forces and torques from the housing to the guiding device is made easier and its fastening is thereby improved.

However, neither the guide rails nor the skids necessarily need to have bearing surfaces which are flat and parallel to each other. Rather, other types are also possible, which permit an insertion of the carriage element into the guiding device in a vertical direction as well as a linear track. For this purpose, tangent planes running transversely are appropriate to the guiding device and the carriage element, which can also be realized with linear or cylindrical skids or rails or with several point-shaped, for example, spherical elements or discontinuous rail sections, which are arranged in a row. These can slide on a plane or, on its part, cambered, for example, cylindrical surface with a corresponding tangent plane.

In an embodiment, one or both of the bearing surfaces adjacent to each other of a guide rail and the associated skid can have a convexly cambered, for example, cylindrical surface area extending in the guiding direction. Although only one essentially linear contact between the guide rail and the skid is thus achieved, the guiding device thus also becomes more insensitive in relation to an imprecise angle orientation of the guide rail and/ or the skid relative to a rotation about an axis parallel to the guiding direction. In place of a slide bearing, the carriage element and the guiding device could also be mounted via rolling body or wheels in a rolling manner.

Preferably, the first tensioning device is located on the bottom edge of the front side of the housing, which lies on the guiding device, and is connected there with the latter for the production of a pre-stressing. On the front side, the tensioning device is also easily actuated for an operator, above all if the front side of the housing lies open, in order to create, for example, access to actuation devices applied to it.

With the first tensioning device, it can be a matter of a beveled tensioning screw, which can transfer a tractive force, through which the housing and guiding device are pressed against each other. The line of action of the force runs preferably transversely, so that it has both a vertical component pre-stressing the front end of the housing against the guiding device, as well as a horizontal component, which can prestress the housing into the receiving device against an end stop.

The second tensioning device can have a bevel arrangement, which has the ability, to convert a force exerted on the housing in a horizontal direction, preferably in a slide-in or guiding direction, into a vertical force directed downwards. The second tensioning device can have a first contact surface connected with the guiding device and a second contact surface connected with the housing, which can be brought into contact with each other, in which they define a preset end position of the slide-in movement of the housing into the receiving device and can form an end stop. An end position of the housing given by contact with the first and second contact surface corresponds preferably to its desired position in the fastened state.

The first and/or the second contact surface can have an inclination at the point of contact between guiding device and housing, which as a reaction to a horizontal force through the wedge effect exerts a force directed vertically downwards on the housing. For example, a section of the housing can have a housing wedge element tapering rearwards, i.e., running transversely downwards, which at a certain point of the slide-in movement of the housing into the receiving device abuts against a guiding wedge element of the guiding device. In the process, the two wedge elements have preferably, but not necessarily, flat parallel surface areas.

Like the bearing surface between the guiding device and the carriage element, one or both of the contact surfaces adjoining each other of the second tensioning device can also have a not flat, but rather, for example, convexly cambered surface area. Crucial for the function based on the wedge effect of the second tensioning device is the position or the angle of the tangent plane of the contact surfaces at the point of contact, which preferably runs transversely rearwards and tilted down. With regard to the static friction coefficients, a too "steep" arrangement of the tangent plane, i.e., approach to the xy-plane, is to be avoided. Conversely, a relatively "flat" tangent plane, i. e., close to the xz-plane, through the wedge effect permits a reinforcement of the force acting in the vertical direction.

But the wedge effect between the first and second contact surface can also be achieved together with any other surface forms, such as, for example, cylindrically or spherically cambered surfaces, as long as in the point of contact with the other participating surfaces they form a tangent plane appropriately inclined, sloping preferably transversely rearwards and down. However, a pointed element could also impinge on a flat or cambered surface, in order to obtain the same effect. Preferably, however, two wedge elements are used with parallel plane surfaces, in order to make possible a flat contact and to minimize the arising stresses as well as the wear and tear.

In a preferred embodiment, in which the housing is located above the guiding devise, the second tensioning device can be situated on the lower edge of the rear side of the housing, which abuts against the guiding device, and produces a compressive force between them.

### Brief Description of the Drawings

A preferred execution example of the invention is depicted in the drawings:
Fig. 1 shows a housing in a perspective view with electronic equipment, which is fastened in an only partially depicted receiving device according to the present invention.
Fig. 2 shows the fastening device from Fig. 1 in a perspective view, in which only two skids from the carriage element are depicted, which lie against the corresponding guide rails of the guiding device.
Fig. 3 shows in an enhanced sectional view one of two beveled tensioning screws shown in Fig. 1 in a tightened state.
Fig. 4 shows in an enhanced sectional view the bevel arrangement shown in Fig. 1.
Fig. 5 shows in an enhanced sectional view the guide rails of the guiding device shown in Fig. 2 as well as the skids of the carriage element in engagement with each other.

### Detailed Description of the Invention

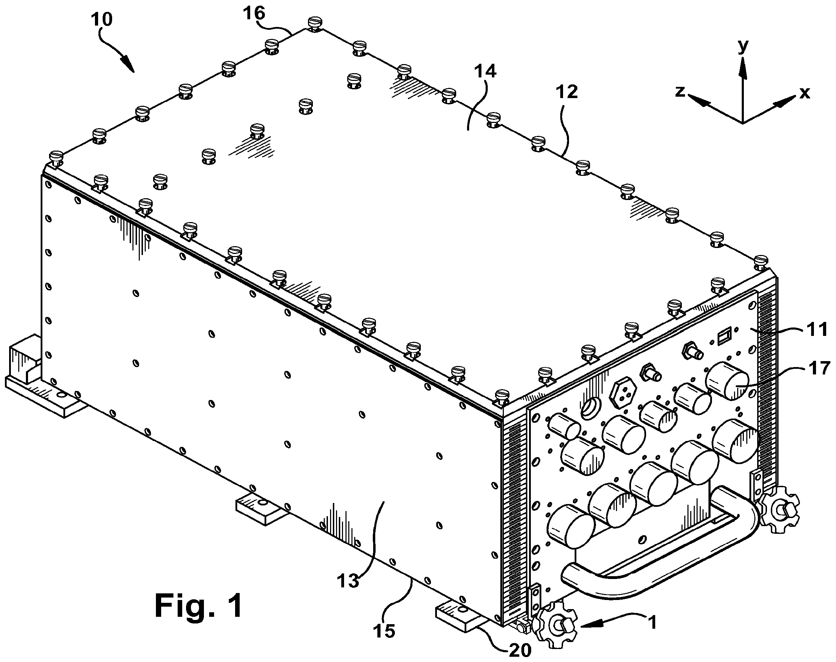

Fig. 1 shows a perspective view of a quadrangular-shaped housing 10, which is fastened with a preferred embodiment of the fastening device 1 according to the present invention. The housing 10 contains electronic equipment of a (not-depicted) aircraft, which is fastened in a frame 20. The housing is connected rigidly with the frame and for this reason with the aircraft and may then also not be unscrewed from its mounting, if vibrations, impacts or other accelerations act upon the frame. The housing 10 has a front wall 11, which contains operating devices 17 of various kinds, such as, for example, plug connectors, switches, rotary knobs, indicating instruments as well as a hand grip, which an operator can use. The housing 10 is in a non-depicted wall, which runs in the plane of the front wall 10, located in an area, in which an operator can remain.

The housing 10 is designed as a slide-in element and furthermore has a right 12 and a left side wall 13, a lid wall 14 and a bottom wall 15 and a rear wall 16, which in the present example have no operating devices and do not need to be accessible to an operator in the slid-in fastened state of the housing 10.

In the Cartesian coordinate system used uniformly in all figures, the y-axis runs vertically from the bottom to the top. The z-axis runs in the horizontal slide-in or guiding direction preset by a guiding device from front to back, and the x-axis runs from the perspective of an operator observing the front wall 11 horizontally from left to right.

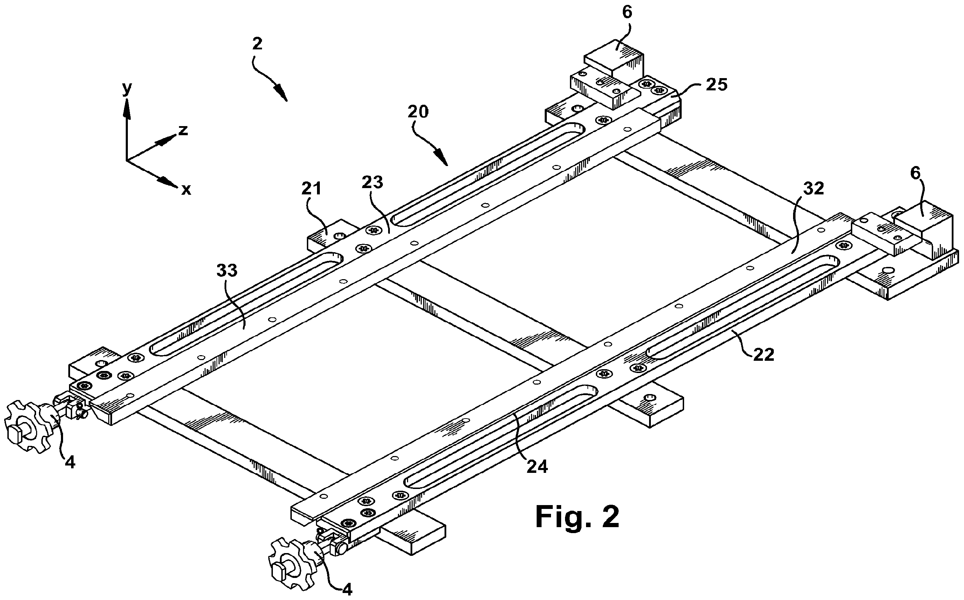

The housing 10 lies on a receiving device 2, which is precisely depicted in Fig. 2, and is fastened to the latter. The frame 20 has a right 22 and a left longitudinal beam 23, which are connected with each other by several cross braces 21. The frame 20 is rigidly connected with the not-depicted structures of the aircraft and resembles a line of rails in its design, in which the parallel longitudinal beams 22, 23 are designed as guide rails and are kept at a preset distance through "ties" 21 lying under them. At their upper edges turned towards each other, the longitudinal beams 22, 23 have respectively a flat surface or bevel 24, 25 beveled at an angle of 45 degrees, extending over their entire length, which form a bearing surface for the gliding, displaceable mounting of a right or left skid 32, 33 of a carriage element. Of the bearing surfaces in Fig. 2, only the rearmost section of the left bearing surface 25 is visible.

The skids 32, 33 are profiles with a trapezoidal cross-section, which has a leg at an angle of 45 degrees to the surfaces of the skids 32, 33 oriented otherwise along the coordinate planes. The skids 32, 33 have in each case a sliding surface 34, 35, which is provided for the flat abutting against the bearing surface 24, 25 of the corresponding guide rail 22, 23.

The skids 32, 33 are screwed together with the bottom wall 15 of the housing. Jointly with the bearing surfaces 24, 25 of the guide rails 22, 23, they define a horizontal guiding direction, which corresponds to the z-direction. On the other hand, they prevent a horizontal lateral movement of the skids 32, 33 and for this reason of the housing 10 relative to the receiving device 2 in the x-direction, if they lie flat against the guide rails 22, 23, as it is depicted in Fig. 2.

However, through the transverse arrangement of the bearing surfaces 24, 25 and of the sliding surfaces 34, 35, it is achieved that the skids 32, 33 and for this reason the housing 10 can be moved upwards in reference to the receiving device, i.e., in the positive y-direction. This is achieved in that against the transversely standing bearing- 24, 25 or sliding-surfaces 34, 35 the guide rails 22, 23 taper upwards or the skids 32, 33 downwards and no undercutting stands in the way of a movement of the housing in the positive y-direction.

The fastening device 1 also has at least a first tensioning device 4 and at least a second tensioning device 6, in which in Fig. 2 in each case a first tensioning device 4 is located at the front end and a second tensioning device 6 at the rear end of each longitudinal beam 22, 23.

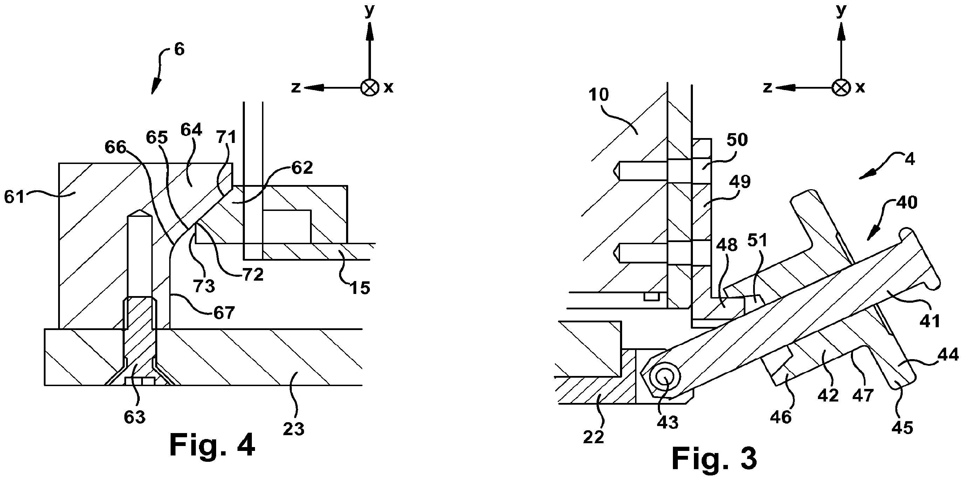

Each of the first or front tensioning devices 4 contains a beveled tensioning screw 40 depicted in detail in Fig. 3, which is equipped for the purpose of pre-stressing the housing 10 in the positive z- and negative y-direction transverse to the receiving device 2. Thus, on the one hand, the effect of the force of gravity of the housing 10, which presses the skids 32, 33 on the guide rails 22, 23, is reinforced at the front end of the housing 10. In order also in the case of strong accelerations to prevent a lifting of the skids off the guide rails through vibrations or impacts, a multiple of the force of gravity can be required as pre-stressing. Furthermore, the beveled tensioning screw prestresses the housing 10 and the skids 32, 33 connected with it in the positive z-direction against an end stop, which is formed by a second or rear tensioning device 6, which is depicted in detail in Fig. 4.

Fig. 3 shows one of the beveled tensioning screws 40 depicted in Fig. 2 in an enhanced sectional view. The beveled tensioning screw 40 has a shaft 41 provided with external screw thread, which is connected via a hinge 43 with the guide rail 22. The swivel axis of the hinge 34 runs in the x-direction, so that the shaft 41 is pivotable in the yz-plane. The shaft 41 bears a screw nut 42 provided with internal screw thread, which has a cylindrical outer surface 47 and a flange 44, which is provided with handle elements 45. The latter make it easier for an operator to unscrew or tighten the screw nut by hand. At its lower end, the screw nut 42 has a pipe section 46, which extends outwards as a continuation of the cylindrical outer surface 47. In its interior, the pipe section 46 has a larger inner diameter than the shaft 41 and no screw thread, so that a ring-shaped clearance 51 exists between the pipe section 46 and the shaft 41.

The clearance 51 is equipped for the reception of an arm 48 of a connector element 49, which is connected via screws 50 with the housing 10. By tightening of the screw nut 42, i.e., by movement of the same towards the hinge 43, the arm 48 is contained in the clearance 51 and clamped between the shaft 41 and the pipe section 46, whereby the screw nut exerts a force on the housing 10 acting essentially in the direction of the shaft, i.e., in the positive z- and negative y-direction. In an unscrewed state of the screw nut 42, the pipe section 46 does not have access to the arm 48. In this condition, the beveled tensioning screw 40 is pivotable about the axis of the hinge 43. As depicted in Fig. 2, the beveled tensioning screw 40 can be pivoted in a horizontal position and in addition further downward. In this position it does not stand in the way of the skids 32, 33, so that the skids can be extracted in the negative z-direction from the receiving device 2 or can be inserted into the latter. A second beveled tensioning screw of the same type is located in the front end of the left guide rail 23.

Fig. 4 shows the second or rear tensioning device 6 located at the rear end of the left guide rail 23 in an enhanced sectional view. Like the front tensioning device 4, the rear tensioning device 6 exists also in twofold, similarly acting, mirror-image designed embodiment at the rear ends of both guide rails 22, 23. In the following, only the rear tensioning device 6 located against the left guide rail 23 is described. The rear tensioning device 6 has a bevel arrangement, which contains a guide wedge element 61 and a housing wedge element 62.

The guide wedge element 61 has a quadrangular-shaped elementary form and a projection 64 located at its upper end, pointing forward and is mounted with a screw 63 on the left guide rail 23. The projection 64 has a transverse, flat, first contact surface 65 pointing downward, which at its rounded edge 66 extending in the x-direction passes over into a perpendicular surface area 67.

The bevel arrangement also includes a housing wedge element 62, which is screwed together with the bottom wall 15 of the housing 10. It could also be directly mounted on the corresponding skid 33. The housing wedge element 62 also has a quadrangular shape, however, at its rear upper edge has a surface or bevel falling off transversely rearward, i.e., in the positive direction at an angle of 45 degrees downward. It forms a second contact surface 71, which is arranged flat and parallel to the first contact surface 65 and is provided for the installation against the same. At its lower end, the second contact surface 71 at an edge 72 passes over into a perpendicular front surface 73.

The rear tensioning device 6 operates as follows: On the one hand, it forms an end stop, which prevents a movement of the housing 10 mounted on the skids 32, 33 in a positive z-direction beyond a preset end position, which is achieved, if the housing wedge element 62 abuts against the guide wedge element 61, so that its contact surfaces 65, 71 lie flat against each other. A wedge effect produced by the inclined position of the surfaces 65, 71 brings about a force acting downwards, i.e., in the negative y-direction on the rear end of the housing 10, which is transferred as compressive force via the rear end of the skids 32, 33 to the rear section of the guide rails 22, 23. This force reinforces the already acting weight of the housing 10 and is so determined, that together with the latter it can also hold the housing fast to the receiving device 2, when, for example, through vibrations or impacts, accelerations act on the housing 10.

In this way, the front tensioning device in the form of the beveled tensioning screw 40 contributes to the vertical fixing of the housing 10 against the receiving device 2 not only directly at the front end, but rather also indirectly at the rear end, while the force component produced by the beveled tensioning screw 40 is "diverted" in the positive z-direction by the bevel arrangement of the rear tensioning device 6 downward in the negative y-direction.

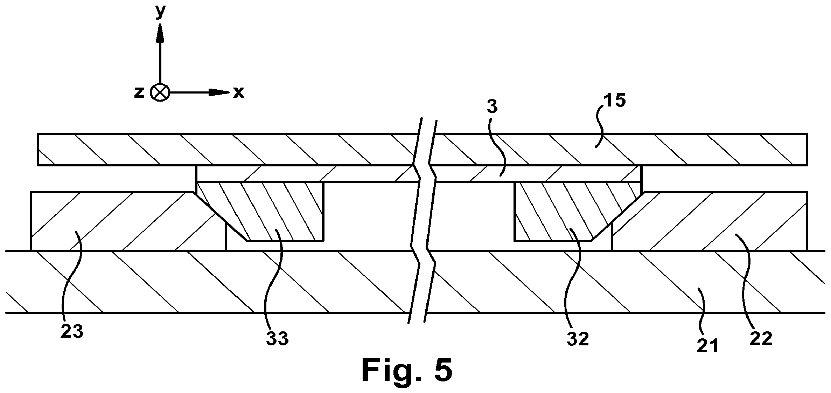

Fig. 5 shows the bottom wall 15 of the housing 10 in enhanced depiction in the cross-section as well as the carriage element 3 with the skids 32, 33 mounted thereon, which lie on the guide rails 22, 23. For improved illustration of the structures essential for the function, the relatively wide middle section between the skids 32, 33 has been omitted. As already described in connection with Fig. 2, the skids 32 and 33 lie against the guide rails 22 or 23 via transverse oppositely inclined surfaces at an angle of 45°. This arrangement creates an advantage according to the present invention in the manner that it affords a linear guiding to the carriage element 3 with the housing 10 and permits a movement in the z-direction without horizontal transverse movement in the x-direction.

Through the lateral guidance thus achieved, the beveled tensioning screws 40 do not need to provide any security function against forces in the x-direction. Thus, a crucial weak point of the beveled tensioning screw is eliminated, which through a force transferring essentially in the longitudinal direction of the shaft 41 offers a sufficient fastening effect only in the y- and z-direction. However, it can only secure the housing 10 insufficiently in the x-direction, because the arm 48 as shown in Fig. 4 is located in a section of the ring-shaped clearance 51 between the shaft 41 and the pipe section 46 extending locally essentially in the x-direction and therefore can easily sink in the x-direction. Furthermore, forces in the x-direction at the tensioning screw 40 would transfer bending moments at the hinge 43, which would have to bear up against the latter. However, through the linear guiding of the carriage element 3, the beveled tensioning screw 40 is released in the x-direction, so that the hinge 43 must absorb only tractive and compressive forces in the yz-plane.

Compared to the fastening of a housing via spikes, the present invention distributes the emerging forces between the guide rails 22, 23 and the skids 32, 33 as well as between the guide wedge element 61 and the housing wedge element 62 to larger surfaces. Through the different arrangement of the beveled surfaces, a fixing of the housing 10 is nevertheless achieved in all three dimensions only through the force applied with the tensioning screws 40.

According to the present invention, the fastening effect is provided in the different directions spatially divided by the element pairs guide rails/skids 22, 23, 32, 33, on the one hand, as well as guide-/housing wedge element 61, 62, on the other hand. Guide rails 22, 23 and skids 32, 33 define the position in the x-direction, whereas the tensioning screw 40 defines a pre-stressing in the negative y-direction. Through the force component in the positive z-direction also produced by the screw 40, the degree of freedom in the z-direction is eliminated through the lying of the housing 62 against the guide wedge element 61. Furthermore, the wedge arrangement 61, 62 also produces a force on the housing in the negative y-direction at the rear end. Moreover, both spatially displaced forces exerted in the negative y-direction also counteract angular acceleration or torques about the x-axis, whereas torques about the y- and z-axis could already be absorbed through the guide rails 22, 23 in conjunction with a pre-stressing in the y-direction acting only at one end.

As another advantage, the present invention proves to be non-sensitive to dimensional deviations of the individual elements. While fastening spikes or recesses provided for their reception have to maintain their dimensions and distances from each other very precisely in several dimensions, the individual surfaces of the elements of the execution examples described can have larger dimensional deviations, without impairing the function of the fastening device 1. The arrangement depicted in Fig. 5 of two guide rails 22, 23 and two skids 32, 33 with angular faces at an angle of, for example, 45° is subject to the automatic centering of the carriage element 3 in the receiving device 2, if the housing 10 is inserted. The angle could also otherwise be selected, whereby, however, in each case symmetrical angular faces at both skids as well as at both guide rails are preferred, in order to prevent the occurrence of lateral forces in the x-direction.

If, for example, the height y or the lateral position x of a guide rail 22, 23 or of a skid 32, 33 digresses marginally from the position provided, this leads only to a marginal displacement of the position of the carriage and for this reason of the housing in the x- and y-direction, without the described function of the fastening device 10 being impaired. Both the beveled tensioning screw 40 as well as the bevel arrangement of the rear tensioning device 6 can continue to completely fulfill their function in the case of marginal deviations in the position of the carriage element 3.

Thus, the tensioning screw 40 can be sufficiently adjusted, for example, in the y- and z-direction by appropriate pivoting of the hinge 43 and screwing down of the screw nut 42, while the arm 48 engages in the ring-shaped clearance 51, which extends here locally approximately in the x-direction and thus provides a sufficient play. Accordingly, the present invention uses the fastening effect of the tensioning screw 40 perceived as insufficient in the x-direction as a play for the adjustment of the exact position of the housing 10.

The effect of the bevel arrangement of the rear tensioning device 6 is not impaired by slight deviations in the position of the housing 10 in the x-direction, while slight deviations in the y-direction only result in an easily displaced point of contact and for this reason at the same time a slight displacement of the housing in the z-direction. However, as explained previously, this is equalized at the front tensioning device 4 by appropriate pivoting and tightening of the tensioning screw 40.

For the mentioned reasons, the tensioning devices 4 and 6 equalize not only deviations in the position of the housing 10 without loss of function, but rather are also tolerant in relation to their own manufacturing tolerances to the wedge elements 61, 62 or the tensioning screw 40.

The invention creates a fastening device 1 for the stationary, detachable mounting of a housing 10 in a receiving device 2. The housing is mounted in a guiding device and is transversely pre-stressed by a front tensioning device 4 with a force component along the guiding device and a force component against the guiding device. A rear tensioning device 6 also produces a force component against the guiding device for the fastening of the housing 10. The fastening device 1 separates the fastening effects in the different spatial directions from each other and thus creates large flat sliding- and bearing-surfaces 24, 25, 34, 35, 67, 71, which are exposed only to slight stresses and may have significant dimensional tolerances without impairment of the fastening effect.

## Claims

1. Fastening device (1) for the stationary, detachable mounting of a housing (10) in a receiving device (2), in which the fastening device has:
a guiding device (22, 23) dedicated to the receiving device (2) for the support and for the guidance of the housing (10), at least one carriage element (3) slidably mountable on the guiding device (22, 23) in a guiding direction (z), which is located on an outer surface (15) of the housing (10) and is convertible in and out of engagement with the guiding device (22, 23),
a first tensioning device (4), which is located adjacent to a front side (11) of the housing (10), in order to stress the housing in a slide-in position at its front end against the guiding device (22, 23),
a second tensioning device (6), which is located adjacent to a rear side (16) of the housing (10), in order to stress the housing in a slide-in position at its rear end against the guiding device (22, 23),
wherein the guiding device has a first guide rail (22), which defines the guiding direction (z), **characterized by** a second guide rail (23),
wherein the first guide rail (22) has at least one transversely arranged bearing surface (24),
wherein the second guide rail (23) of the guiding device has at least a second, transversely arranged bearing surface (25), in which both of the bearing surfaces (24, 25) form a guideway with a trapezoidal cross-section.

2. Fastening device (1) according to Claim 1, in which the guide rail (22, 23) produces a lateral guide.

3. Fastening device (1) according to Claim 1, in which the guiding direction (z) runs horizontally.

4. Fastening device (1) according to Claim 1, in which the carriage element (3) has at least one skid (32, 33), which has at least one transversely arranged bearing surface (34, 35) .

5. Fastening device (1) according to Claim 4, in which the carriage element (3) has at least a second, transversely arranged bearing surface (34, 35), in which both of the bearing surfaces (34, 35) form a guideway with a trapezoidal cross-section.

6. Fastening device (1) according to Claim 1, in which the outer surface, at which the carriage element (3) is located, is a floor area (15) of the housing (10).

7. Fastening device (1) according to Claim 1, with which the first tensioning device (4) contains a beveled tensioning screw (40).

8. Fastening device (1) according to Claim 1, with which the frist tensioning device (4) is located on a lower edge of the front side (11) of the housing (10).

9. Fastening device (1) according to Claim 1, in which the second tensioning device (6) contains a bevel arrangement (65, 71), which has a first contact surface (65) connected with the guiding device and a second contact surface (71) connected with the housing.

10. Fastening device (1) according to Claim 9, in which the first and the second contact surfaces (65, 71) are parallel flat surfaces, the first contact surface (65) is a surface area of a guide wedge element (61) connected with the guiding device (22, 23) and the second contact surface (71) is a surface area of a housing wedge element (62) connected with the housing (10).

11. Fastening device (1) according to Claim 1, in which the second tensioning device (6) is located at the lower end of the rear side (16) of the housing (10).

12. Fastening device (1) according to Claim 1, in which the first (4) and the second tensioning device (6) stress the housing against the guiding device (22, 23 in the vertical direction (y).

## Patentansprüche

1. Befestigungsvorrichtung (1) zur ortsfesten, lösbaren Anbringung eines Gehäuses (10) in einer Aufnahmevorrichtung (2), wobei die Befestigungsvorrichtung aufweist:
eine Führungsvorrichtung (22, 23), die der Aufnahmevorrichtung (2) zur Halterung und zur Führung des Gehäuses (10) fest zugeordnet ist,
mindestens ein Schlittenelement (3), das an der Führungsvorrichtung (22, 23) in einer Führungsrichtung (z) gleitbeweglich angebracht werden kann, das sich an einer Außenfläche (15) des Gehäuses (10) befindet und in und außer Eingriff mit der Führungsvorrichtung (22, 23) gebracht werden kann,
eine erste Spannvorrichtung (4), die sich angrenzend an eine Vorderseite (11) des Gehäuses (10) befindet, um das Gehäuse an seinem vorderen Ende gegen die Führungsvorrichtung (22, 23) in eine Einschubposition zu beaufschlagen,
eine zweite Spannvorrichtung (6), die sich angrenzend an eine Rückseite (16) des Gehäuses (10) befindet, um das Gehäuse an seinem hinteren Ende gegen die Führungsvorrichtung (22, 23) in eine Einschubposition zu beaufschlagen,
wobei die Führungsvorrichtung eine erste Führungsschiene (22) hat, welche die Führungsrichtung (z) vorgibt,
**gekennzeichnet durch**
eine zweite Führungsschiene (23),
wobei die erste Führungsschiene (22) mindestens eine quer angeordnete Auflagefläche (24) hat,
wobei die zweite Führungsschiene (23) der Führungsvorrichtung zumindest eine zweite, quer angeordnete Auflagefläche (25) hat,
wobei beide der Auflageflächen (24, 25) eine Führungsbahn mit einem trapezförmigen Querschnitt bilden.

2. Befestigungsvorrichtung (1) nach Anspruch 1, wobei die Führungsschiene (22, 23) eine seitliche Führung herstellt.

3. Befestigungsvorrichtung (1) nach Anspruch 1, wobei die Führungsrichtung (z) horizontal verläuft.

4. Befestigungsvorrichtung (1) nach Anspruch 1, wobei das Schlittenelement (3) mindestens eine Gleitkufe (32, 33) hat, die mindestens eine quer angeordnete Auflagefläche (34, 35) hat.

5. Befestigungsvorrichtung (1) nach Anspruch 4, wobei das Schlittenelement (3) zumindest eine zweite, quer angeordnete Auflagefläche (34, 35) hat, wobei beide der Auflageflächen (34, 35) eine Führungsbahn mit einem trapezförmigen Querschnitt bilden.

6. Befestigungsvorrichtung (1) nach Anspruch 1, wobei es sich bei der Außenfläche, an der sich das Schlittenelement (3) befindet, um eine Bodenfläche (15) des Gehäuses (10) handelt.

7. Befestigungsvorrichtung (1) nach Anspruch 1, bei der die erste Spannvorrichtung (4) eine abgeschrägte Spannschraube (40) enthält.

8. Befestigungsvorrichtung (1) nach Anspruch 1, bei der sich die erste Spannvorrichtung (4) an einem unteren Rand der Vorderseite (11) des Gehäuses (10) befindet.

9. Befestigungsvorrichtung (1) nach Anspruch 1, wobei die zweite Spannvorrichtung (6) eine Schrägenanordnung (65, 71) enthält, die eine erste Kontaktfläche (65), die mit der Führungsvorrichtung verbunden ist, und eine zweite Kontaktfläche (71) hat, die mit dem Gehäuse verbunden ist.

10. Befestigungsvorrichtung (1) nach Anspruch 9, wobei es sich bei der ersten und der zweiten Kontaktfläche (65, 71) um parallele, flache Flächen handelt, die erste Kontaktfläche (65) ein Oberflächenbereich eines mit der Führungsvorrichtung (22, 23) verbundenen Führungskeilelements (61) und die zweite Kontaktfläche (71) ein Oberflächenbereich eines mit dem Gehäuse (10) verbundenen Gehäusekeilelements (62) ist.

11. Befestigungsvorrichtung (1) nach Anspruch 1, wobei sich die zweite Spannvorrichtung am unteren Ende der Rückseite (16) des Gehäuses (10) befindet.

12. Befestigungsvorrichtung (1) nach Anspruch 1, wobei die erste (4) und die zweite Spannvorrichtung (6) das Gehäuse gegen die Führungsvorrichtung (22, 23) in der vertikalen Richtung (y) beaufschlagen.

## Revendications

1. Dispositif de fixation (1) pour le montage stationnaire détachable d'un boîtier (10) dans un dispositif de réception (2), sachant que le dispositif de fixation comporte :
un dispositif de guidage (22, 23) dédié au dispositif de réception (2) pour le support et pour le guidage du boîtier (10),
au moins un élément chariot (3) monté de façon coulissante sur le dispositif de guidage (22, 23) dans une direction de guidage (z), lequel est situé sur une surface extérieure (15) du boîtier (10) et est permutable en et hors prise avec le dispositif de guidage (22, 23),
un premier dispositif de serrage (4), lequel est situé de façon adjacente à un côté avant (11) du boîtier (10), afin de serrer le boîtier dans une position de mise en place par coulissement à son extrémité avant contre le dispositif de guidage (22, 23),
un deuxième dispositif de serrage (6), lequel est situé de façon adjacente à un côté arrière (11) du boîtier (10), afin de serrer le boîtier dans une position de mise en place par coulissement à son extrémité arrière contre le dispositif de guidage (22, 23),
sachant que le dispositif de guidage présente un premier rail de guidage (22), lequel définit la direction de guidage (z),
**caractérisé par**
un deuxième rail de guidage (23),
sachant que le premier rail de guidage (22) présente au moins une surface d'appui (24) agencée transversalement,
sachant que le deuxième rail de guidage (23) du dispositif de guidage présente au moins une deuxième surface d'appui (25) agencée transversalement,
les deux surfaces d'appui (24, 25) formant un chemin de guidage de section transversale trapézoïdale.

2. Dispositif de fixation (1) selon la revendication 1, sachant que le rail de guidage (22, 23) fournit un guidage latéral.

3. Dispositif de fixation (1) selon la revendication 1, sachant que la direction de guidage (z) s'étend horizontalement.

4. Dispositif de fixation (1) selon la revendication 1, sachant que l'élément chariot (3) présente au moins un châssis (32, 33), lequel présente au moins une surface d'appui (34, 35) agencée transversalement.

5. Dispositif de fixation (1) selon la revendication 4, sachant que l'élément chariot (3) présente au moins une deuxième surface d'appui (34, 35) agencée transversalement, les deux surfaces d'appui (34, 35) formant un chemin de guidage de section transversale trapézoïdale.

6. Dispositif de fixation (1) selon la revendication 1, sachant que la surface extérieure, au niveau de laquelle l'élément chariot (3) est situé, est une aire de fond (15) du boîtier (10).

7. Dispositif de fixation (1) selon la revendication 1, sachant que le premier dispositif de serrage (4) contient une vis de serrage (40) biseautée.

8. Dispositif de fixation (1) selon la revendication 1, sachant que le premier dispositif de serrage (4) est situé sur un bord inférieur du côté avant (11) du boîtier (10).

9. Dispositif de fixation (1) selon la revendication 1, sachant que le deuxième dispositif de serrage (6) contient un agencement en biseau (65, 71), lequel présente une première surface de contact (65) raccordée au dispositif de guidage et une deuxième surface de contact (71) raccordée au boîtier.

10. Dispositif de fixation (1) selon la revendication 9, sachant que la première et la deuxième surface de contact (65, 71) sont des surfaces planes parallèles, la première surface de contact (65) est une aire de surface d'un élément de coin de guidage (61) raccordé au dispositif de guidage (22, 23) et la deuxième surface de contact (71) est une aire de surface d'un élément de coin de boîtier (62) raccordé au boîtier (10).

11. Dispositif de fixation (1) selon la revendication 1, sachant que le deuxième dispositif de serrage (6) est situé à l'extrémité inférieure du côté arrière (16) du boîtier (10).

12. Dispositif de fixation (1) selon la revendication 1, sachant que le premier (4) et le deuxième dispositif de serrage (6) serrent le boîtier contre le dispositif de guidage (22, 23) dans la direction verticale (y).
